# EUROPEAN PATENT APPLICATION

(11) **EP 3 667 740 A1**
(43) Date of publication of application: **17.06.2020**
(21) Application number: 18844559.7
(22) Date of filing: 19.04.2018
(51) Int. Cl.: H01L 31/054, H02S 20/10, H02S 20/32, H02S 40/22, H02S 40/42

(54) **CONCENTRATOR PHOTOVOLTAIC MODULE, CONCENTRATOR PHOTOVOLTAIC PANEL, CONCENTRATOR PHOTOVOLTAIC DEVICE, AND METHOD FOR MANUFACTURING CONCENTRATOR PHOTOVOLTAIC MODULE**

(30) Priority: 07.08.2017 JP 2017152471
(71) Applicant: Sumitomo Electric Industries, Ltd., Osaka-shi, Osaka 541-0041 (JP)
(72) Inventor: NAGAI, Youichi, Osaka-shi, Osaka 541-0041 (JP); IYATANI, Kazushi, Osaka-shi, Osaka 541-0041 (JP); UEYAMA, Munetsugu, Osaka-shi, Osaka 541-0041 (JP); INAGAKI, Makoto, Osaka-shi, Osaka 541-0041 (JP); ABIKO, Yoshiya, Osaka-shi, Osaka 541-0041 (JP)
(74) Representative: Boult Wade Tennant LLP
(86) International application number: PCT/JP2018/016102
(87) International publication number: WO 2019/030989

(57) **Abstract**

A concentrator photovoltaic module includes: a concentrating portion configured by arranging a plurality of Fresnel lenses that concentrate sunlight; a plurality of power generating elements arranged at positions corresponding respectively to the plurality of Fresnel lenses; a plurality of ball lenses that are provided corresponding respectively to the plurality of power generating elements and guide the sunlight concentrated by the plurality of Fresnel lenses to the plurality of power generating elements; and a housing (11) that contains the plurality of ball lenses and the plurality of power generating elements. The housing (11) includes a resin frame body (16), and a metal bottom plate (15) that is fixed to the frame body (16), and on an inner surface of which the plurality of ball lenses and the plurality of power generating elements are arranged. A plurality of columnar heat-dissipating members (40), extending along an outer surface (15b) of the bottom plate (15) and dissipating the heat of the bottom plate (15) outward, are attached to the outside surface (15b) of the bottom plate (15).

## Description

### TECHNICAL FIELD

The present invention relates to a concentrator photovoltaic module, a concentrator photovoltaic panel, a concentrator photovoltaic apparatus, and a method for manufacturing a concentrator photovoltaic module.

This application claims the priority based on Japanese Patent Application No. 2017-152471 filed on Aug. 7, 2017, and incorporates all the contents described in the above Japanese application.

### BACKGROUND ART

Units that constitute a basic unit of an optical system in a concentrator photovoltaic apparatus include a unit provided with a primary concentrating lens that is a convex lens, a secondary concentrating lens that is a spherical lens, and a power generating element, for example, (e.g., see Patent Literature 1 (FIG. 8)). For the power generating element, a solar cell made of a compound semiconductor element with high power generation efficiency is used. Sunlight is concentrated by the primary concentrating lens and incident on the secondary concentrating lens, and is further concentrated by the secondary concentrating lens and reaches the power generating element.

With such a configuration, a large amount of light energy can be concentrated on the small power generating element, and power can be generated with high efficiency. A large number of such concentrator photovoltaic units are arranged in a matrix to form a concentrator photovoltaic module, and a large number of such modules are arranged in a matrix to form a concentrator photovoltaic panel. The concentrator photovoltaic panel constitutes a concentrator photovoltaic apparatus together with a drive device configured to cause the panel to face the sun and follow the movement of the sun.

In the concentrator photovoltaic module, a large number of power generating elements are mounted on the surface of a bottom plate of a housing. For this bottom plate, a thin metal plate (e.g., aluminum, etc.) may be used from the viewpoint of ensuring thermal dissipation while holding down manufacturing cost. Moreover, a frame body that forms the outer frame of the housing supports the outer edge of the bottom plate. A resin material may be used for this frame body in order to hold down the manufacturing cost.

### CITATION LIST

### [PATENT LITERATURE]

Patent Literature 1: US Patent Application Publication No. US2010/0236603 A1

### SUMMARY OF INVENTION

### TECHNICAL PROBLEM

A concentrator photovoltaic module according to an embodiment includes: a concentrating portion configured by arranging a plurality of concentrating lenses that concentrate sunlight; a plurality of power generating elements arranged at positions corresponding respectively to the plurality of concentrating lenses; a plurality of secondary concentrating lenses that are provided corresponding respectively to the plurality of power generating elements and guide the sunlight concentrated by the plurality of concentrating lenses to the plurality of power generating elements; and a housing that contains the plurality of secondary concentrating lenses and the plurality of power generating elements. The housing includes a resin frame body, and a metal bottom plate that is fixed to the frame body, and on an inner surface of which the plurality of secondary concentrating lenses and the plurality of power generating elements are arranged. One or more heat-dissipating members are attached to an outer surface of the bottom plate, the one or more heat-dissipating members having a columnar shape that extends along the outer surface of the bottom plate and dissipating heat of the bottom plate outward.

Another embodiment is a concentrator photovoltaic panel comprising a plurality of the concentrator photovoltaic modules described above that are arranged.

Furthermore, another embodiment is a concentrator photovoltaic apparatus including: the concentrator photovoltaic panel described above; and a drive device that drives the concentrator photovoltaic panel to face the sun and follow movement of the sun.

Further, another embodiment is a method for manufacturing the above-described concentrator photovoltaic module that is attached to a concentrator photovoltaic apparatus, in which after an intermediate assembly, obtained by attaching the concentrating portion to the housing that contains the plurality of power generating elements and the plurality of secondary concentrating lenses, is attached to an attachment rail of the concentrator photovoltaic apparatus, the one or more heat-dissipating members are attached to the outer surface of the bottom plate.

### BRIEF DESCRIPTION OF DRAWINGS

[FIG. 1] FIG. 1 is a perspective view showing an example of a concentrator photovoltaic apparatus.
[FIG. 2] FIG. 2 is an enlarged perspective view showing an example of a concentrator photovoltaic module.
[FIG. 3] FIG. 3 is an enlarged perspective view of flexible printed circuits.
[FIG. 4] FIG. 4 is a view schematically showing a positional relationship between one Fresnel lens and a power generating element in a package disposed at a position corresponding to the Fresnel lens.
[FIG. 5] FIG. 5 is a perspective view showing a housing according to the first embodiment.
[FIG. 6] FIG. 6 is a sectional view along a longitudinal direction of a housing.
[FIG. 7] FIG. 7A is a partially enlarged view of the inner surface of a bottom plate, and FIG. 7B is an enlarged view of a groove portion.
[FIG. 8] FIG. 8 is a view showing a part of arrangement of the groove portions on the inner surface of the bottom plate.
[FIG. 9] FIG. 9 is a view showing the outer surface of the bottom plate.
[FIG. 10] FIG. 10 is a partial sectional view of a bottom plate to which a heat-dissipating member is attached.
[FIG. 11] FIG. 11 is a diagram showing some of steps in a method for manufacturing the module.
[FIG. 12] FIG. 12A is a partial sectional view of a bottom plate showing a modification of the heat-dissipating member, and FIG. 12B is a partial sectional view of the bottom plate showing another modification of the heat-dissipating member.

### DESCRIPTION OF EMBODIMENTS

### [Technical problem]

In the concentrator photovoltaic module, the power generation efficiency of the power generating element mounted on the bottom plate of the housing may decrease due to an increase in temperature. For this reason, the power generating element is configured to prevent the temperature rise by dissipating heat to the metal bottom plate.

The metal bottom plate has high thermal conductivity and good thermal dissipation, while easily expanding thermally. Thus, when the expansion of the bottom plate in a surface direction is restricted by the resin frame body, the bottom plate may bend so as to bulge in a convex shape toward the outside of the surface due to the difference in thermal expansion coefficient between the resin and the metal, and the position of the power generating element may deviate from a position where the power generating element should be, to cause a decrease in power generation efficiency.

In particular, when the bottom plate bends in a convex shape in a direction toward the inside of the housing due to thermal expansion and the power generating element moves closer to the primary concentrating lens, the light concentration range of the primary concentrating lens on the light incident surface (upper surface) of the secondary concentrating lens becomes larger than the light incident surface (diameter) of the secondary concentrating lens, and a leakage of concentrated light may occur.

As described above, the concentrator photovoltaic module has a problem where the power generation efficiency decreases due to the temperature rise of the power generating element and the accompanying bending of the bottom plate.

In particular, when the concentrator photovoltaic module is installed in a high-temperature region and a temperature rise during power generation becomes very high, there is a risk that heat dissipation from the bottom plate to the outside is not in time, and the temperature rise of the power generating element and the warping of the bottom plate become remarkable, thus further lowering the power generation efficiency.

The present disclosure has been made in view of such circumstances, and an object of the present disclosure is to provide a concentrator photovoltaic module that can enhance thermal dissipation while preventing bending of a bottom plate.

### [Advantageous effects of disclosure]

According to the present disclosure, it is possible to enhance thermal dissipation while preventing the bending of the bottom plate.

### [Description of embodiments]

First, the contents of the embodiment will be listed and described.
(1) A concentrator photovoltaic module according to an embodiment includes: a concentrating portion configured by arranging a plurality of concentrating lenses that concentrate sunlight; a plurality of power generating elements arranged at positions corresponding respectively to the plurality of concentrating lenses; a plurality of secondary concentrating lenses that are provided corresponding respectively to the plurality of power generating elements and guide the sunlight concentrated by the plurality of concentrating lenses to the plurality of power generating elements; and a housing that contains the plurality of secondary concentrating lenses and the plurality of power generating elements. The housing includes a resin frame body, and a metal bottom plate that is fixed to the frame body, and on an inner surface of which the plurality of secondary concentrating lenses and the plurality of power generating elements are arranged. One or more heat-dissipating members are attached to an outer surface of the bottom plate, the one or more heat-dissipating members having a columnar shape that extends along the outer surface of the bottom plate and dissipating heat of the bottom plate outward.
   According to the photovoltaic module having the above configuration, since the columnar heat-dissipating member that extends along the outer surface of the bottom plate and dissipates the heat of the bottom plate to the outside is attached to the outer surface of the bottom plate, the heat of the power generating element which conducts to the bottom plate can be effectively dissipated by the heat-dissipating member. At the same time, the bottom plate can be reinforced from the outer surface side by the heat-dissipating member, and the rigidity of the bottom plate can be enhanced. As a result, it is possible to enhance the thermal dissipation while preventing the bending of the bottom plate due to thermal expansion.
(2) In the photovoltaic module, it is preferable that the one or more heat-dissipating members be prismatic pipe members made of metal.
   In this case, the prismatic pipe member, which has a relatively high bending strength in the longitudinal direction by having a corner portion along the longitudinal direction, is provided along the bottom plate, whereby the bottom plate can be effectively reinforced, and the pipe member can be attached with one-side surface facing the bottom plate, so that more area to be thermally connected to the bottom plate can be ensured. Moreover, by using the pipe member, a wider surface area as the heat-dissipating member can be ensured, and the heat can be dissipated more effectively.
(3) In the photovoltaic module, it is preferable that the frame body include a frame main body portion that configures an outer frame, and a bottom plate holding portion that extends along the inner surface of the bottom plate inside the frame main body portion and is integral with the frame main body portion at both ends, and a longitudinal direction of the one or more heat-dissipating members intersect with a longitudinal direction of the bottom plate holding portion.
   In this case, the bottom plate can be reinforced in multiple directions from both the outer surface and the inner surface by the heat-dissipating member and the bottom plate holding portion the longitudinal directions of which intersect with each other, and the rigidity of the bottom plate can further be enhanced.
(4) In the photovoltaic module, it is preferable that the one or more heat-dissipating members be attached to the outer surface of the bottom plate via an adhesive layer having thermal conductivity.
   In this case, after the housing is assembled, the heat-dissipating member can be attached to the outer surface of the bottom plate. Therefore, for example, after the concentrator photovoltaic module is installed in an installation location, the number of heat-dissipating members to be attached can be adjusted in accordance with the environment of the installation location.
(5) In the photovoltaic module, it is preferable that the adhesive layer be configured using at least one of a caulking material having thermal conductivity and a tape having thermal conductivity.
   In this case, since there is no need to use a bolt, a nut, a rivet, or the like, the heat-dissipating member can be easily attached after the housing is assembled.
(6) Another embodiment is a concentrator photovoltaic panel comprising a plurality of the concentrator photovoltaic modules described above that are arranged.
   With this configuration, it is possible to enhance the thermal dissipation while preventing the bending of the bottom plate.
(7) Further, another embodiment is a concentrator photovoltaic apparatus including: the concentrator photovoltaic panel described above; and a drive device that drives the concentrator photovoltaic panel to face the sun and follow movement of the sun.
   With this configuration, it is possible to enhance the thermal dissipation while preventing the bending of the bottom plate.
(8) Moreover, another embodiment is a method for manufacturing the above-described concentrator photovoltaic module that is attached to a concentrator photovoltaic apparatus, in which after an intermediate assembly, obtained by attaching the concentrating portion to the housing that contains the plurality of power generating elements and the plurality of secondary concentrating lenses, is attached to an attachment rail of the concentrator photovoltaic apparatus, the one or more heat-dissipating members are attached to the outer surface of the bottom plate.

With this configuration, after the intermediate assembly is attached to the attachment rail of the concentrator photovoltaic apparatus, the heat-dissipating members are attached to the outer surface of the bottom plate to be completed as the concentrator photovoltaic module. Therefore, for example, after the concentrator photovoltaic apparatus is installed in the installation location, the number of heat-dissipating members to be attached can be adjusted in accordance with the environment of the installation location.

### [Details of embodiments]

Hereinafter, preferred embodiments will be described with reference to the drawings.

In addition, at least a part of each embodiment described below may be combined in a freely selectable manner.

### [Concentrator photovoltaic apparatus and concentrator photovoltaic panel]

First, the configuration of the concentrator photovoltaic apparatus will be described.

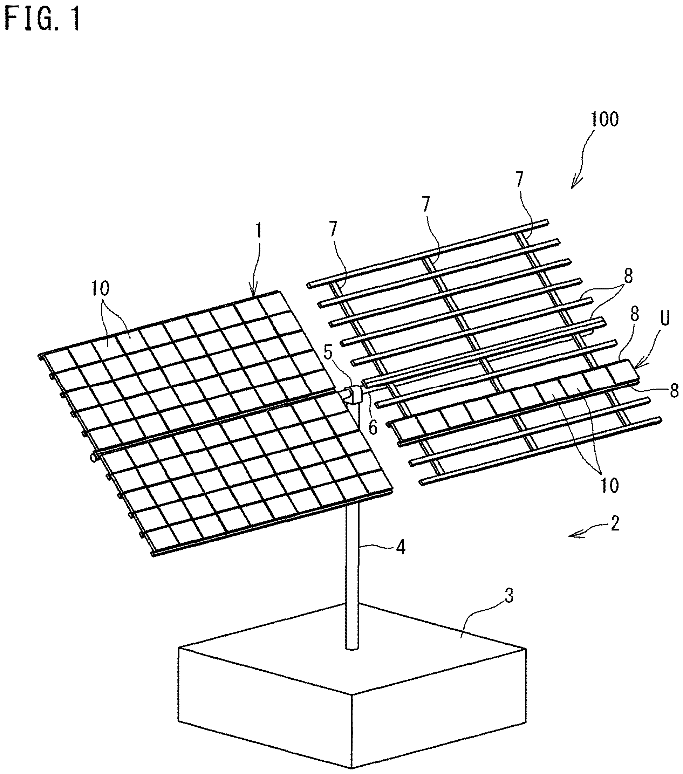

FIG. 1 is a perspective view showing an example of a concentrator photovoltaic apparatus.

In FIG. 1, a concentrator photovoltaic apparatus 100 includes a concentrator photovoltaic panel 1 having a panel divided into two, right and left, wings, and a pedestal 2 that supports the concentrator photovoltaic panel 1 on the back-surface side.

In FIG. 1, the panel 1 on the right side of the page is shown with a part of the photovoltaic panel 1 omitted to show the structure of the pedestal 2.

The pedestal 2 includes a base 3 and a support portion 4 standing on the base 3. The base 3 is fixed to the ground. The support portion 4 is provided vertically. A drive device 5 is provided at a support point of the photovoltaic panel 1 at the upper end of the support portion 4. The drive device 5 drives the photovoltaic panel 1 so as to rotate in a direction of an elevation angle about a horizontally extending shaft 6. Further, the drive device 5 drives the photovoltaic panel 1 so as to rotate in a direction of an azimuth angle about the support portion 4.

The drive device 5 is controlled by a control device (not shown). The control device has a drive circuit for driving a built-in motor of the drive device 5. By the operation of the motor (stepping motor) of each shaft, the photovoltaic panel 1 can take an attitude of any angle with respect to each of the azimuth angle and the elevation angle.

The control device controls the drive device 5 so that the photovoltaic panel 1 faces the sun and follows the movement of the sun.

The shaft 6 driven by the drive device 5 is provided with a plurality of beams 7 in a direction orthogonal to the shaft 6. The photovoltaic panel 1 is fixed on the upper sides of the plurality of beams 7. The photovoltaic panel 1 is configured by, for example, arranging units U each made up of ten concentrator photovoltaic modules 10 arranged in a horizontal row in multiple stages.

The unit U includes a plurality of concentrator photovoltaic modules 10 and a pair of upper and lower attachment rails 8 that integrally fix the concentrator photovoltaic modules 10 in a state of being aligned in a row.

Each unit U is spanned over each beam 7 and fixed to the upper side of each beam 7.

Each wing of the photovoltaic panel 1 is made up of ten units U, for example. Thus, each wing of the photovoltaic panel 1 is configured by arranging 10 × 10 concentrator photovoltaic modules 10 in a matrix. Therefore, there are 200 concentrator photovoltaic modules 10 in the photovoltaic panels 1 of both wings.

### [Concentrator photovoltaic modules]

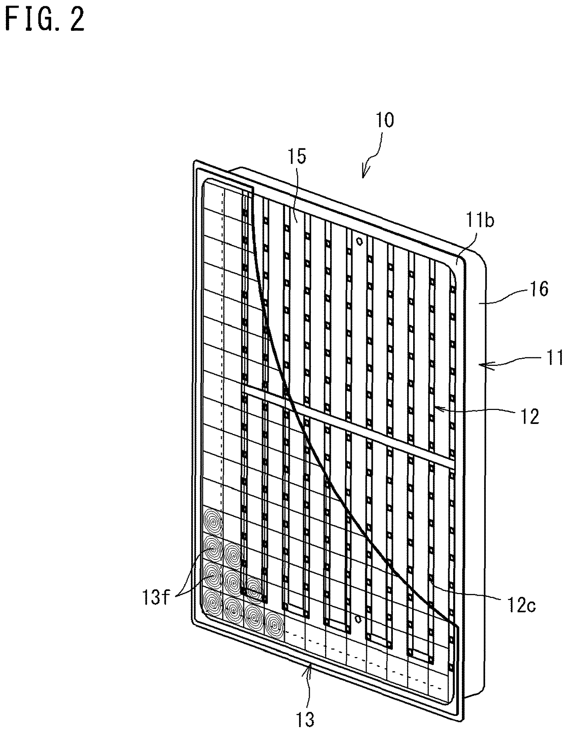

FIG. 2 is an enlarged perspective view showing an example of the concentrator photovoltaic module (hereinafter also simply referred to as the module) 10 (a part of the concentrating part 13 has been broken). In FIG. 2, the module 10 includes, as major components, a box-shaped housing 11, flexible printed circuits 12 arranged in a plurality of rows on a bottom plate 15 of the housing 11, and a concentrating portion 13 attached to a flange portion 11b of the housing 11 like a lid.

The concentrating portion 13 is a Fresnel lens array and is configured by arranging a plurality (e.g., 14 × 10 = 140) of Fresnel lenses 13f that concentrate sunlight. Such a concentrating portion 13 can be formed by, for example, using a glass plate as a base material and forming a silicone resin film on the back surface (inner surface) thereof. The Fresnel lens 13f is formed on this resin film.

The housing 11 includes the bottom plate 15 on which the flexible printed circuits 12 are disposed, and a frame body 16 to which the outer edge of the bottom plate 15 and the like are attached, and which holds the concentrating portion 13 so as to face the bottom plate 15. The housing 11 will be described in detail later.

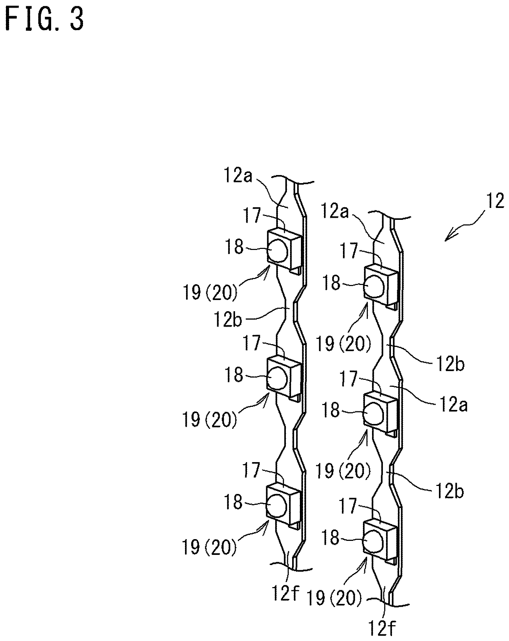

FIG. 3 is an enlarged perspective view of the flexible printed circuits 12.

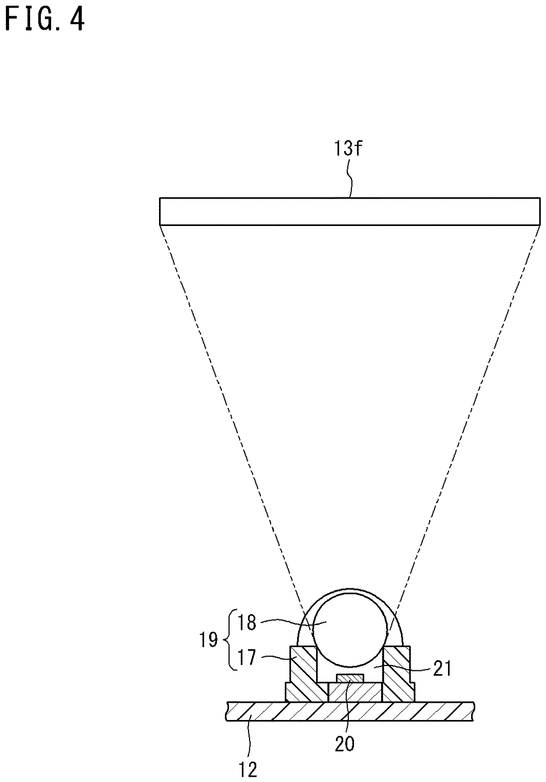

In FIG. 3, the flexible printed circuit 12 of the present example is configured including a flexible substrate 12f on which a conductive pattern (not shown) is formed. A plurality of power generating elements (not shown in FIG. 4) are mounted on the flexible printed circuit 12. The power generating element is incorporated inside a package 17.

Each power generating element is disposed at a position corresponding to each of the plurality of Fresnel lenses 13f.

A ball lens 18 which is a secondary concentrating lens is attached onto the package 17. The package 17 including the power generation element and the ball lens 18 constitute a secondary concentrating part 19.

The flexible printed circuit 12 is formed such that a wide portion 12a formed to have a large width and provided with the power generating element and the secondary concentrating portion 19, and a narrow portion 12b narrower than the wide portion 12a are arranged alternately. This saves material for the substrate.

FIG. 4 is a view schematically showing the positional relationship between one Fresnel lens 13f and the power generating element in the package 17 disposed at a position corresponding to the Fresnel lens. In FIG. 4, the package 17 mounted on the flexible printed circuit 12 is shown in cross section.

As shown in FIG. 4, a power generating element 20 is mounted on the flexible printed circuit 12 in a state surrounded by the package 17. As the power generating element 20, a solar cell made of a compound semiconductor element with high power generation efficiency is used.

The ball lens 18 which is a spherical lens is supported at the upper end of the package 17 slightly away (floating) from the power generating element 20 and is disposed immediately before the power generating element 20.

The power generating element 20 and the ball lens 18 are disposed so as to substantially coincide with the optical axis of the Fresnel lens 13f as a primary concentrating lens. Hence the sunlight concentrated by the Fresnel lens 13f is guided to the power generating element 20 by the ball lens 18.

In this manner, the plurality of power generating elements 20 are arranged at positions corresponding to the respective Fresnel lenses 13f. The ball lens 18 is provided corresponding to each of the plurality of power generating elements.

A space between the power generating element 20 and the ball lens 18 in the package 17 is a sealing portion 21 filled with translucent resin. The power generating element 20 is hermetically sealed by the sealing portion 21 so that moisture, dust, and the like are prevented from adhering to the power generating element 20. The resin for the sealing portion 21 is, for example, silicone, and is poured in a liquid state and solidifies to become the sealing portion 21.

### [Housing]

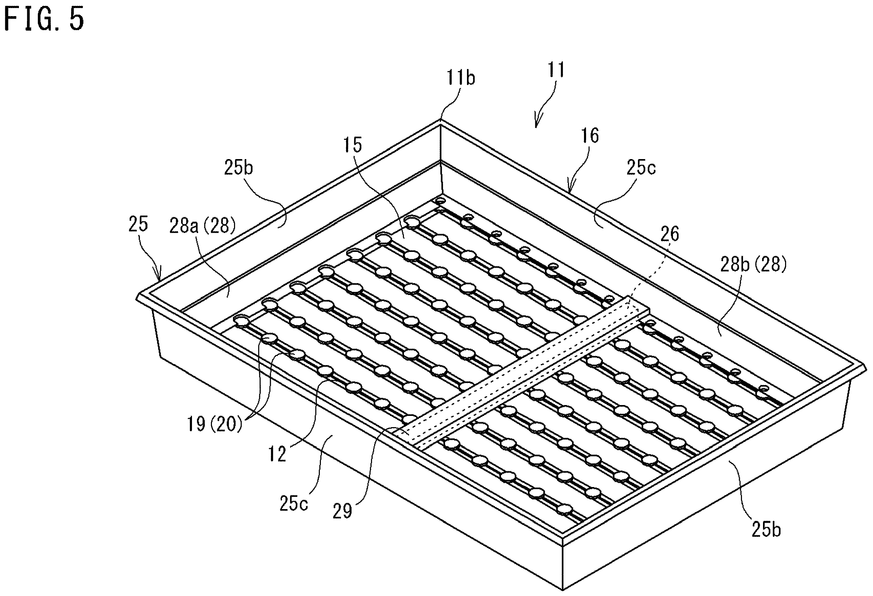

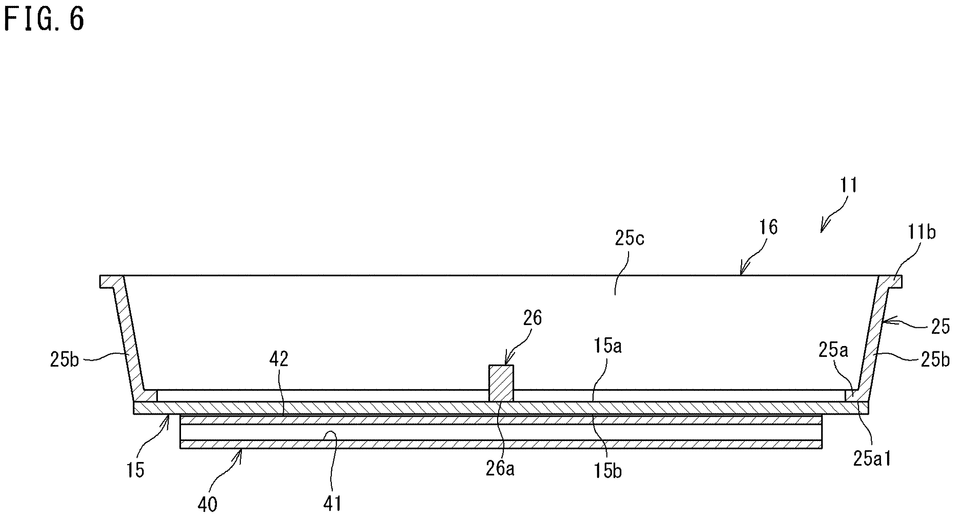

FIG. 5 is a perspective view showing the housing 11, and FIG. 6 is a sectional view along the longitudinal direction of the housing 11. In FIGS. 5 and 6, the housing 11 is formed in a box shape (here, a rectangle (may be a square)) having a long side and a short side, and the housing 11 is configured by attaching the bottom plate 15 made of an aluminum alloy, for example, to the frame body 16 made of resin.

In addition, as shown in FIG. 6, a plurality of heat-dissipating members 40 made of a prismatic pipe member are attached to the bottom plate 15.

In FIG. 6, a protective member 28 and a shielding member 29 to be described later are omitted.

The frame body 16 is formed of a resin material, such as poly butylene terephtalate (PBT) resin filled with glass fiber, and includes a frame main body portion 25 that forms an outer frame (side wall frame), and a bottom plate holding portion 26 formed integrally with the frame main body portion 25 inside the frame main body portion 25.

The frame main body portion 25 is formed by integrally forming a base portion 25a formed in a rectangular frame shape, and a pair of short-side wall portions 25b and a pair of long-side wall portions 25c protruding from the top of the base portion 25a. The outer edge of the bottom plate 15 is fixed to the bottom surface of the base portion 25a by a fastening member and an adhesive layer (not shown). Further, as described above, the flange portion 11b to which the concentrating portion 13 (cf. FIG. 2) is attached is formed at the respective upper ends of the short-side wall portion 25b and the long-side wall portion 25c.

The bottom plate holding portion 26 is formed, for example, in a prismatic shape, and extends along the short-side direction of the housing 11 at substantially the central portion of the bottom plate 15.

Both ends in the longitudinal direction of the bottom plate holding portion 26 are connected to the inner surface of the long-side wall portion 25c. Thereby, the longitudinal central portion of the long-side wall portion 25c is prevented from being deformed so as to warp inward or outward.

Further, the bottom surface 26a of the bottom plate holding portion 26 is substantially flush with a bottom surface 25a1 of the base portion 25a and is in contact with the inner surface 15a of the bottom plate 15. Thereby, the bottom plate holding portion 26 holds the inner surface 15a of the bottom plate 15.

The bottom surface 26a of the bottom plate holding portion 26 and the inner surface 15a of the bottom plate 15 are bonded and fixed to each other by the adhesive layer made of a caulking material or the like.

As shown in FIG. 5, the casing 11 further includes the protective member 28 attached to the frame body 25, and the shielding member 29 that covers the bottom plate holding part 26. The protective member 28 is made up of a short-side protective plate 28a that covers the entire lower half of the inner surface of the short-side wall portion 25b, and a long-side protective plate 28b that covers the entire lower half of the inner surface of the long-side wall portion 25c. The protective member 28 and the shielding member 29 are made of, for example, an aluminum alloy metal plate.

The respective lower ends of the short-side protective plate 28a and the long-side protective plate 28b are bent inward and also cover the upper surface of the base portion 25a protruding inward from the short-side wall portion 25b and the long-side wall portion 25c.

When the Fresnel lens 13f (cf. FIG. 2) of the concentrating portion 13 deviates from the power generating element 20 (secondary concentrating lens 18) adjacent to the frame main body portion 25, the protective member 28 prevents the base portion 25a, the short-side wall portion 25b, and the long-side wall portion 25c of the frame main body portion 25 from being directly irradiated with the concentrated sunlight and from being damaged thermally.

Further, the shielding member 29 prevents the bottom plate holding portion 26 from being directly irradiated with the sunlight concentrated by the Fresnel lens 13f due to the sunlight shifting from the original concentrating position, and prevents the bottom plate holding portion 26 from being damaged thermally.

The bottom plate 15 is formed in a rectangular shape having a long side and a short side in accordance with the base portion 25a of the frame body 16, and bonded and fixed to the base portion 25a and the bottom plate holding portion 26 of the frame body 16 as described above. The bottom plate 15 is a plate material made of an aluminum alloy as described above, and is configured to conduct the heat of the power generating element 20 to the bottom plate 15 and prevent a rise in the temperature of the power generating element 20 during power generation.

In the following description, in FIG. 6, a direction in which the inner surface 15a of the bottom plate 15 on the inner side of the housing 11 faces (the upward direction on the paper) is referred to as a direction toward the inside of the housing, and an outer surface 15b of the bottom plate 15 on the outer side of the housing 11 faces (the downward direction on the paper) is referred to as a direction toward the outside of the housing.

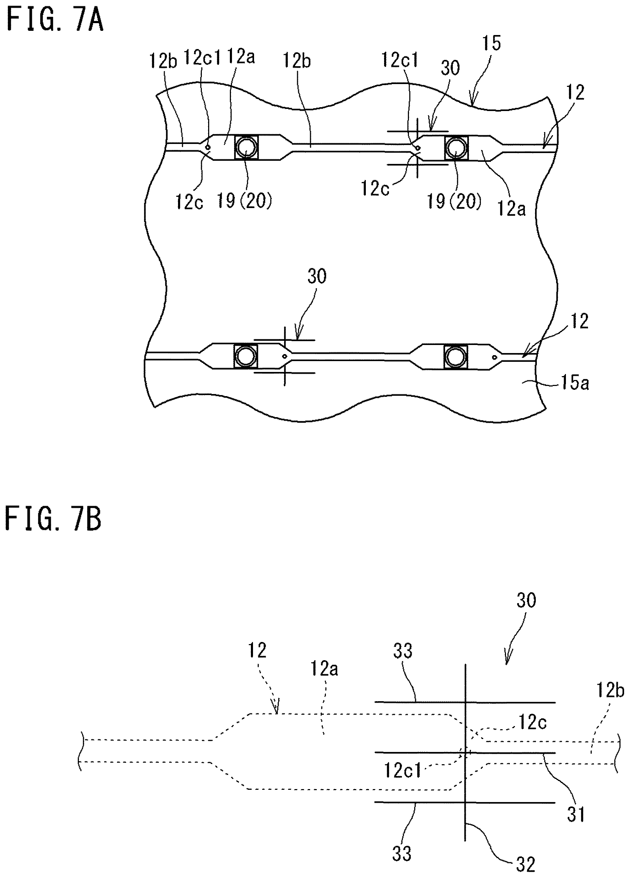

FIG. 7A is a partially enlarged view of the inner surface of the bottom plate 15.

As shown in FIG. 7A, the flexible printed circuits 12, on each of which the secondary concentrating portions 19 and the power generating elements 20 are mounted, are arranged so as to form a plurality of rows on the inner surface 15a of the bottom plate 15.

The flexible printed circuit 12 is disposed such that its longitudinal direction is parallel to a long-side direction which is a direction parallel to the long side of the bottom plate 15.

On the inner surface 15a, there is a groove portion 30 formed of a minute groove recessed with respect to the inner surface 15a around a portion where the boundary portion 12c, located between a wide portion 12a and a narrow portion 12b of the flexible printed circuit 12, is disposed.

A plurality of groove portions 30 are provided to be spotted at positions where the boundary portions 12c of the flexible printed circuit 12 are disposed in the attachment position of the flexible printed circuit 12 on the inner surface 15a of the bottom plate 15.

Accordingly, the plurality of groove portions 30 function as markers for positioning the flexible printed circuit 12 at the time of attaching the flexible printed circuit 12.

FIG. 7B is an enlarged view of the groove portion 30. In FIG. 7B, the flexible printed circuit 12 is indicated by a broken line.

As shown in FIG.7B, the groove portion 30 is configured including: a first groove 31 formed linearly along the longitudinal direction of the flexible printed circuit 12 (the long-side direction of the bottom plate 15) at substantially the center in the width direction of the flexible printed circuit 12; a linear second groove 32 that intersects with the first groove 31; and a pair of third grooves 33 that are parallel to the first groove 31 and formed linearly on both sides of the first groove 31.

The first groove 31, the second groove 32, and the third groove 33 constituting the groove portion 30 are minute grooves that are recessed with respect to the inner surface 15a and are formed by pressing, a marking needle, or the like. For example, the groove width and groove depth of each of the first groove 31, the second groove 32, and the third groove 33 are about several hundredths of a millimeter. The plate thickness of the bottom plate 15 is about 1 mm.

Further, in the present embodiment, the length of each of the first groove 31, the second groove 32, and the third groove 33 constituting the groove portion 30 has been set to about 20 mm, and the interval between the first groove 31 and the third groove 33 has been set to 5 mm.

The first groove 31 and the pair of third grooves 33 indicate an approximate position of the boundary portion 12c of the flexible printed circuit 12.

Further, as shown in FIGS. 7A and 7B, a hole 12c1 is formed in the boundary portion 12c of the flexible printed circuit 12. The flexible printed circuit 12 is attached such that the intersection of the first groove 31 and the second groove 32 is exposed from the hole 12c1. As a result, the flexible printed circuit 12 can be positioned and attached to the groove portion 30 with high precision in the hole 12c1.

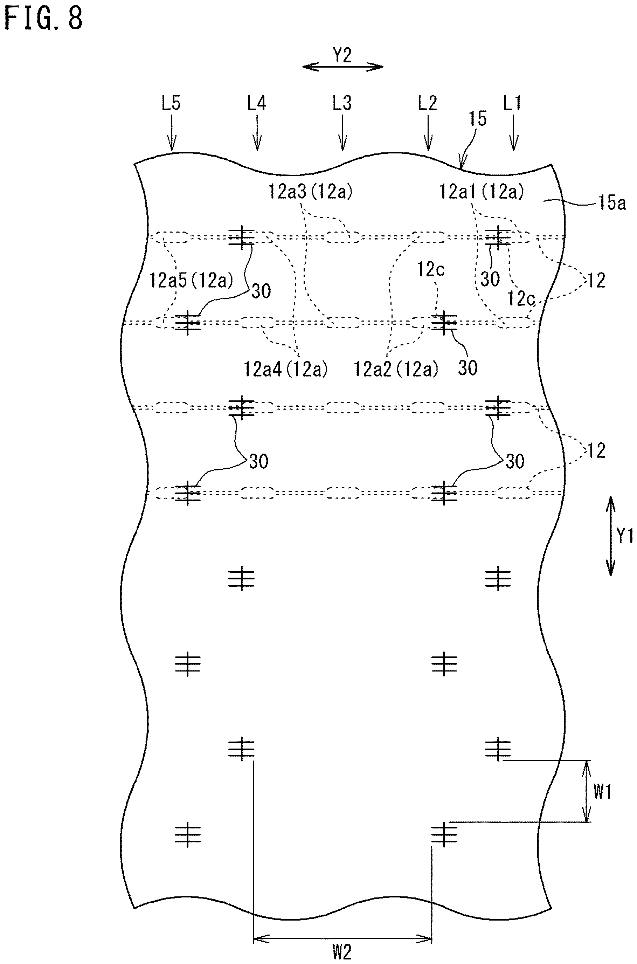

FIG. 8 is a view showing a part of the arrangement of the groove portions 30 on the inner surface 15a of the bottom plate 15. In FIG. 8, an arrow Y1 indicates a short-side direction parallel to the short side of the bottom plate 15. An arrow Y2 indicates the long-side direction of the bottom plate 15. In FIG. 8, the flexible printed circuit 12 is indicated by a broken line, and some of the plurality of rows of the flexible printed circuits 12 are omitted.

As shown in FIG. 8, the flexible printed circuits 12 are arranged in a plurality of rows at equal intervals with a predetermined pitch.

Further, the wide portions 12a of the flexible printed circuits 12 are disposed along the short-side direction.

Therefore, the wide portions 12a of the flexible printed circuits 12 are arranged at equal intervals along the long-side direction and at equal intervals along the short-side direction.

The plurality of groove portions 30 are arranged along the long-side direction and the short-side direction.

In the short-side direction, the groove portions 30 are arranged at the same distance as the pitch between two adjacent rows of the plurality of rows of flexible printed circuits 12.

The arrangement in the short-side direction of the groove parts 30 is made with reference to a pair of rows in the short-side direction made up of a pair of adjacent wide parts 12a.

In FIG. 8, a row L1 formed of a plurality of wide portions 12a1 arranged in the short-side direction and a row L2 formed of a plurality of wide portions 12a2 arranged in the short-side direction constitute a pair of rows in the short-side direction made up of a pair of adjacent wide portions 12a.

The groove portions 30 are arranged along the short-side direction by being alternately formed at the position of the boundary portion 12c located inside between the row L1 formed of the wide portions 12a1 and the row L2 formed of the wide portions 12a2.

For example, in FIG. 8, the groove portion 30 disposed on the rightmost side of the uppermost stage is formed at the position of the boundary portion 12c on the wide portion 12a2 side in the wide portion 12a1 belonging to the row L1.

The groove portion 30 adjacent in the short-side direction to the groove portion 30 disposed on the rightmost side of the uppermost stage is formed at the position of the boundary portion 12c on the wide portion 12a1 side in the wide portion 12a2 belonging to the row L2.

As thus described, the groove portions 30 are arranged at equal intervals along the short-side direction with reference to a pair of rows in the short-side direction made up of a pair of adjacent wide portions 12a.

Further, in FIG. 8, a row L4 formed of a plurality of wide portions 12a4 arranged in the short-side direction and a row L5 formed of a plurality of wide portions 12a5 arranged in the short-side direction also constitute a pair of rows in the short-side direction made up of a pair of wide portions 12a adjacent to each other.

Therefore, the groove portions 30 are arranged along the short-side direction with reference to the row L4 formed of the plurality of wide portions 12a4 and the row L5 formed of the plurality of wide portions 12a5.

A row L3 in the short-side direction formed of a plurality of wide portions 12a3 arranged in the short-side direction is interposed between the pair of rows L1, L2 in the short-side direction made up of the wide portions 12a1, 12a2 and the pair of rows L4, L5 in the short-side direction made up of the wide portions 12a4, 12a5.

For this reason, the groove portions 30 are arranged along the long-side direction at a certain distance by sandwiching two wide portions 12a adjacent to each other among the wide portions 12a arranged in the long-side direction.

Here, in FIG. 8, an interval W1 between the pair of groove portions 30 adjacent to each other in the short-side direction is narrower than an interval W2 between the pair of groove portions 30 adjacent to each other in the long-side direction.

Here, the interval W2 indicates the minimum interval between columns made up of the plurality of groove portions 30 arranged along the short-side direction.

For example, when the long side of the bottom plate 15 is 800 mm and the short side is 600 mm, the interval W1 is set to 50 mm and the interval W2 is set to 130 mm. In this case, there are four rows in which the groove portions 30 are arranged along the short-side direction, and ten rows in which the groove portions 30 are arranged along the long-side direction.

As thus described, a plurality of groove portions 30 are provided to be spotted at positions corresponding to the attachment position of the flexible printed circuit 12 on the inner surface 15a of the bottom plate 15, whereby the groove portion 30 functions as a positioning marker for the flexible printed circuit 12 at the time of attachment of the flexible printed circuit 12 to the inner surface 15a.

Further, the plurality of groove portions 30 have a function of reducing thermal expansion on the inner surface 15a side of the bottom plate 15.

In the groove portion 30 that is a minute groove, when the bottom plate 15 thermally expands, the groove width of each of the grooves 31, 32, 33 constituting the groove portion 30 is narrowed. The amount of expansion in the surface direction of the bottom plate 15 is reduced by the amount by which the groove width of each of the grooves 31, 32, 33 is narrowed.

Thus, on the inner surface 15a that is the surface provided with the groove portion 30, when the bottom plate 15 thermally expands, the width of each of the grooves 31, 32, 33 constituting the groove portion 30 is narrowed, and the amount of expansion in the surface direction on the inner surface 15a side is reduced.

On the other hand, the groove part 30 is not formed on the outer surface 15b (FIG. 6) that is the surface of the bottom plate 15 opposite to the inner surface 15a. Therefore, the amount of expansion on the outer surface 15b of the bottom plate 15 is relatively large, with no groove portion 30 being formed thereon.

That is, since the groove portion 30 for reducing the thermal expansion on the inner surface 15a side of the bottom plate 15 is provided on the inner surface 15a of the bottom plate 15, when the bottom plate 15 thermally expands, the amount of expansion due to the thermal expansion on the inner surface 15a side can be made relatively smaller than the amount of expansion on the outer surface 15b side.

For this reason, when the bottom plate 15 is thermally expanded, the bottom plate 15 can be bent so as to protrude in the direction toward the outside of the housing, and as a result, the bottom plate 15 can be prevented from bending in the direction toward the inside of the housing due to the thermal expansion.

Further, since each groove portion 30 includes the first groove 31 formed linearly along the long-side direction of the bottom plate 15 and the linear second groove 32 intersecting with the first groove 31, the direction in which the thermal expansion is reduced by the groove portion 30 can be made multidirectional within the inner surface 15a, and the position on the bottom plate 15 can be clearly displayed by the groove portion 30.

Moreover, in the present embodiment, the interval W1 between the pair of groove portions 30 adjacent to each other in the short-side direction is narrower than the interval W2 between the pair of groove portions 30 adjacent to each other in the long-side direction. Thereby, more groove portions 30 are arranged along the short-side direction, and hence the groove portions 30 can be arranged so as to divide the bottom plate 15 in the long-side direction. As a result, it is possible to facilitate the bending in the direction toward the outside of the housing in the long-side direction in which the bottom plate is likely to bend as compared to the short-side direction, and it is possible to facilitate the bottom plate 15 to bend so as to protrude in the direction toward the outside of the housing when the bottom plate expands thermally.

In addition, in the present embodiment, the frame body 16 constituting the housing 11 includes the frame main body portion 25 that forms the outer frame, and the bottom plate holding portion 26 extending along the inner surface 15a of the bottom plate 15 and formed integrally with the frame main body portion 25 inside the frame main body portion 25, so that the bottom plate holding portion 26 can prevent the bottom plate 15 from bending in the direction toward the inside of the housing due to thermal expansion.

In addition, since the plurality of groove portions 30 of the present embodiment function as markers for positioning the flexible printed circuit 12, it is not necessary to separately provide a marker for positioning the flexible printed circuit 12, and man-hours and cost can be reduced.

### [Heat-dissipating member]

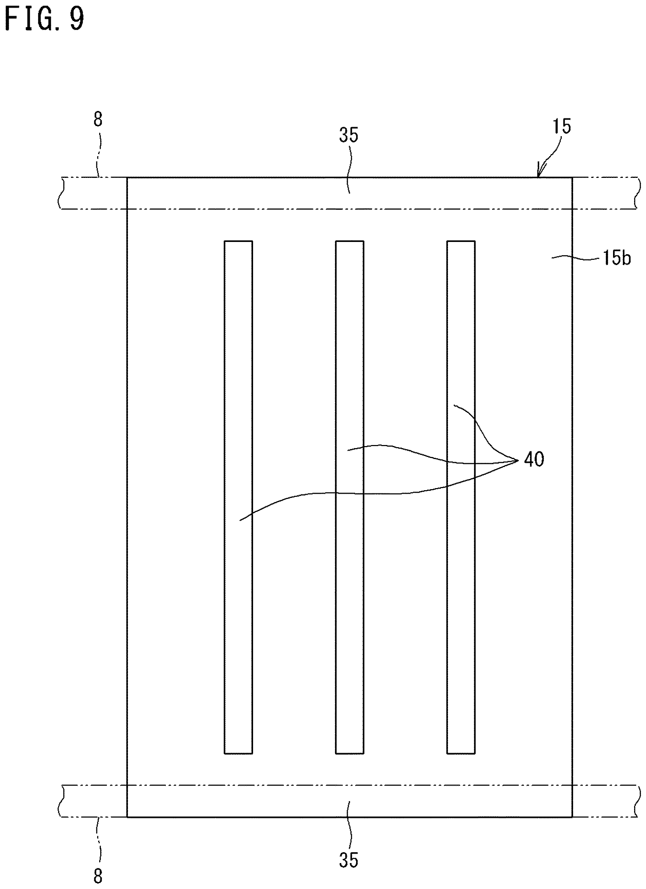

FIG. 9 is a view showing the outer surface 15b of the bottom plate 15. As shown in FIG. 9, at the side edge of each short side on the outer surface 15b of the bottom plate 15, an attachment portion 35 is ensured, where the attachment rails 8 (FIG. 1) for fixing a plurality of modules 10 are in contact and fixed. The module 10 is fixed to the attachment rail 8 with bolts, nuts or the like in a state where the attachment portion 35 is in contact with the attachment rail 8, to constitute the unit U described above. The module 10 is attached to the concentrator photovoltaic apparatus 100 as the unit U. At this time, a portion except for the attachment portion 35 on the outer surface 15b of the bottom plate 15, the portion being in contact with the attachment rail 8, is exposed outward.

Referring also to FIG. 6, the heat-dissipating member 40 is attached to the outer surface 15b of the bottom plate 15 as described above. The heat-dissipating member 40 is attached to the portion of the outer surface 15b of the bottom plate 15 which is exposed to the outside of the attachment portion 35.

The heat-dissipating member 40 is a member for dissipating the heat of the bottom plate 15 to the outside and is formed of, for example, a quadrangular columnar pipe member made of an aluminum alloy. In the present embodiment, a plurality of (three in the illustrated example) heat-dissipating members 40 are arranged and attached to the outer surface 15b of the bottom plate 15.

The heat-dissipating member 40 is formed in a column shape extending along the outer surface 15b of the bottom plate 15 and is disposed in parallel with the long-side direction of the bottom plate 15. Hence the longitudinal direction of the heat-dissipating member 40 intersects with the longitudinal direction of the bottom plate holding portion 26.

Further, the longitudinal direction of the heat-dissipating member 40 also intersects with the longitudinal direction of the attachment rail 8 configured to attach the module 10 to the concentrator photovoltaic apparatus 100.

Each end of the heat-dissipating member 40 extends to the vicinity of the attachment portion 35. Thereby, the heat-dissipating member 40 is formed to have as large a length as possible while the attachment portion 35 is ensured.

Since the module 10 is attached to the pair of upper and lower attachment rails 8, there is a risk that bending rigidity in the long-side direction is lower than bending rigidity in the short-side direction. However, as described above, by causing the longitudinal direction of the heat-dissipating member 40 to intersect with the longitudinal direction of the attachment rail 8, the bending rigidity in the long-side direction of (the bottom plate 15 of) the module 10 can be enhanced, and the bending in the long-side direction can be prevented.

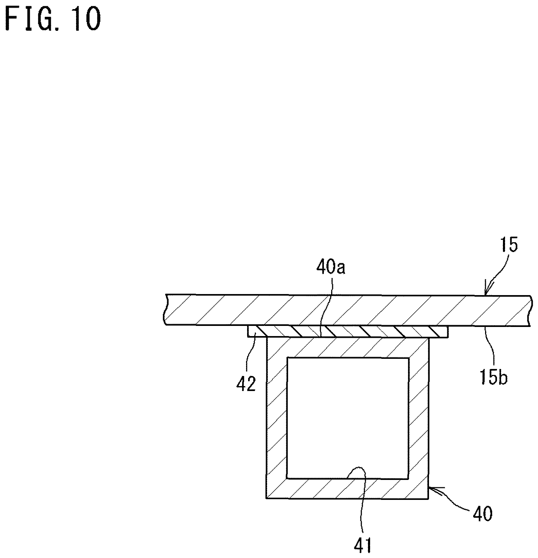

FIG. 10 is a partial sectional view of the bottom plate 15 to which the heat-dissipating member 40 is attached.

As shown in FIG. 10, the heat-dissipating member 40 is a pipe member having inside a through-hole 41 square in cross section.

The heat-dissipating member 40 is attached to the outer surface 15b of the bottom plate 15 with an adhesive layer 42 interposed therebetween.

The heat-dissipating member 40 is attached with one-side surface 40a facing the outer surface 15b. Therefore, the adhesive layer 42 is interposed between the one-side surface 40a and the outer surface 15b of the bottom plate 15.

The adhesive layer 42 is formed by curing a caulking material having thermal conductivity, and is interposed between the one-side surface 40a and the outer surface 15b to adhere and fix the heat-dissipating member 40 to the bottom plate 15. Further, the adhesive layer 42 has thermal conductivity, thereby thermally connecting the heat-dissipating member 40 and the bottom plate 15.

As described above, since the heat-dissipating member 40 is attached to the outer surface 15b of the bottom plate 15 with the adhesive layer 42 interposed therebetween, the heat-dissipating member 40 can be attached to the outer surface 15b of the bottom plate 15 after the housing 11 is assembled. Therefore, for example, after the module 10 is installed in the installation location, the number of heat-dissipating members 40 to be attached can be adjusted in accordance with the environment of the installation location.

In addition, with the adhesive layer 42 being formed by curing the caulking material, it is not necessary to use bolts, nuts, rivets, or the like, and the heat-dissipating member 40 can be easily attached to the outer surface 15b of the bottom plate 15 after the housing 11 is assembled.

In the module 10 of the present embodiment, since the columnar heat-dissipating member 40 that extends along the outer surface 15b of the bottom plate 15 and dissipates the heat of the bottom plate 15 to the outside is attached to the outer surface 15b of the bottom plate 15, the heat of the power generating element 20 which conducts to the bottom plate 15 can be effectively dissipated by the heat-dissipating member 40. At the same time, the bottom plate 15 can be reinforced from the outer surface 15b side by the heat-dissipating member 40, and the rigidity of the bottom plate 15 can be enhanced. As a result, it is possible to enhance the thermal dissipation while preventing the bending of the bottom plate 15 due to thermal expansion.

Further, the heat-dissipating member 40 is the quadrangular columnar pipe member made of an aluminum alloy, and with the use of the prismatic pipe member having corner portions along the longitudinal direction to have a relatively high bending strength in the longitudinal direction, it is possible to effectively reinforce the bottom plate 15.

Since having the quadrangular columnar shape, the heat-dissipating member 40 can be attached with the one-side surface 40a facing the bottom plate 15, and a large area can be ensured for thermal connection to the bottom plate 15 as compared to, for example, a heat-dissipating member circular in cross section. Moreover, by using the pipe member, a wider surface area as the heat-dissipating member 40 can be ensured, and the heat can be dissipated more effectively.

Further, since the longitudinal direction of the heat-dissipating member 40 intersects with the longitudinal direction of the bottom plate holding portion 26, the bottom plate 15 can be reinforced in multiple directions from both the outer surface 15b and the inner surface 15a, and the rigidity of the bottom plate 15 can further be enhanced.

After the housing 11 of the module 10 is attached to the concentrator photovoltaic apparatus 100, the heat-dissipating member 40 can be completed as the module 10 by being attached to the housing 11.

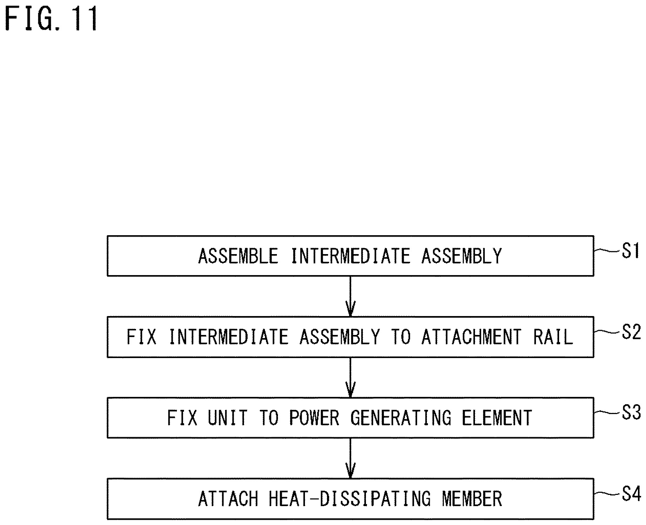

FIG. 11 is a diagram showing some of steps in a method for manufacturing the module 10.

First, as shown in FIG. 11, there is obtained an intermediate assembly with the concentrating portion 13 attached to the housing 11 containing the plurality of ball lenses 18 and the plurality of power generating elements 20 by providing the flexible printed circuit 12 on the bottom plate 15 (step S1). The heat-dissipating member 40 has not been attached to the intermediate assembly.

As described above, the intermediate assembly refers to the one with the concentrating portion 13 attached to the housing 11 containing the plurality of ball lenses 18 and the plurality of power generating elements 20 by providing the flexible printed circuit 12 on the bottom plate 15, and refers to the one having completed the assembly as the module 10 except for the attachment of the heat-dissipating member 40.

Next, a plurality of intermediate assemblies are fixed to the attachment rail 8 to obtain a unit having the plurality of intermediate assemblies integrally fixed thereto (step S2).

Then, the unit is fixed to the beam 7 (FIG. 1) of the concentrator photovoltaic apparatus 100 (step S3). Thereby, the intermediate assembly is attached to the concentrator photovoltaic apparatus 100.

At this time, as described above, the portion except for the attachment portion 35 on the outer surface 15b of the bottom plate 15, the portion being in contact with the attachment rail 8, is exposed outward.

Therefore, after step S3, the heat-dissipating member 40 is attached to the outer surface 15b of the bottom plate 15 of the intermediate assembly attached to the concentrator photovoltaic apparatus 100 (step S4).

As thus described, in the module 10 of the present embodiment, after the intermediate assembly is attached to the attachment rail 8 of the concentrator photovoltaic apparatus 100, the heat-dissipating members 40 are attached to the outer surface 15b of the bottom plate 15 to be completed as the concentrator photovoltaic module 10. Therefore, for example, after the concentrator photovoltaic apparatus 100 is installed in the installation location, the number of heat-dissipating members 40 to be attached can be adjusted in accordance with the environment of the installation location.

### [Verification test]

Next, a verification test performed using the module 10 according to the above embodiment will be described.

As an example product 1, the concentrator photovoltaic module described in the first embodiment was used. As an example product 2, a module was used which was different from the module of the above embodiment in that the groove portion 30 is not provided on the inner surface 15a of the bottom plate 15. Further, as a comparative example product, a module was used which was different from the module of the above embodiment in that the groove portion 30 or the heat-dissipating member 40 is not provided. The example products 1, 2 and the comparative example product were caused to generate power under the same conditions, and the amount of bending of the bottom plate 15 and the temperature of the power generating element at that time were compared. Note that the amount of bending was obtained with reference to a plane determined by the bottom surface of the base portion of the frame body, and the amount of bending in a location where the bending was the largest among the entire bottom plate was employed.

As the test conditions, the example product and the comparative example product were caused to generate power for a certain period of time at an outside air temperature of 50 degrees.

As a result of the test, in the example products 1, 2, the amount of bending of the bottom plate was bent in a range of 0.5 mm in both the direction toward the inside of the housing and the direction toward the outside of the housing. On the other hand, in the comparative example product, the amount of bending of the bottom plate was 5 mm, and the bottom plate bent in the direction toward the inside of the housing.

Further, the temperature of the power generating element according to each of the example products 1, 2 was 95 degrees, while the temperature of the power generating element according to the comparative example product was 105 degrees.

From these results, it was possible to confirm that, according to the module of the present embodiment, the thermal dissipation can be enhanced while the bending of the bottom plate can be prevented.

### [Others]

The embodiments disclosed herein should be considered as illustrative and non-restrictive in every respect.

The heat-dissipating member 40 shown in the above embodiment is an example and can be changed as appropriate.

In the above embodiment, the case has been illustrated where the plurality of heat-dissipating members 40 are arranged in parallel to the long-side direction of the bottom plate 15. However, for example, the heat-dissipating members 40 may be arranged in parallel to the short-side direction of the bottom plate 15 or may be arranged in a direction intersecting with both sides. Only one or two heat-dissipating members 40 may be arranged, or a larger number of the heat-dissipating members 40 than the number (three) in the above embodiment may be arranged.

Further, in the above embodiment, the case has been illustrated where the quadrangular columnar pipe member is used as the heat-dissipating member 40, but for example, a triangular columnar member may be used, or a pentagonal or more prismatic member may be used.

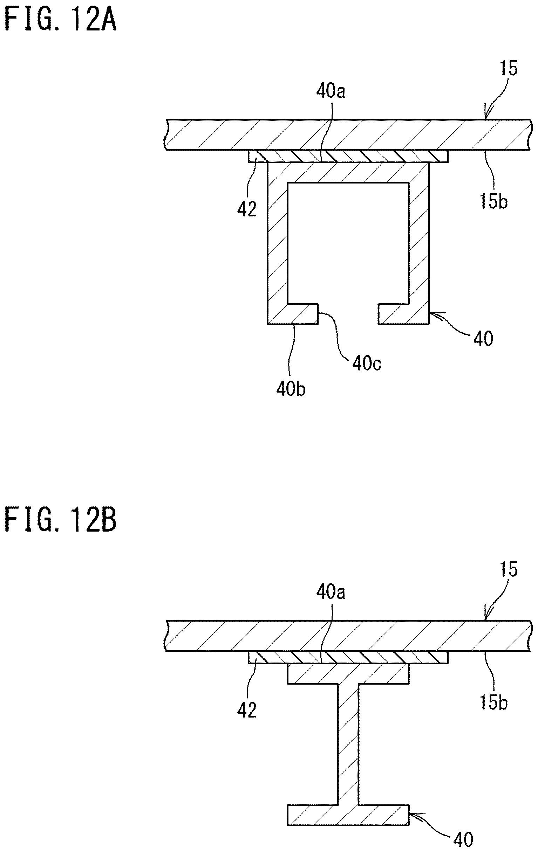

Moreover, in the above embodiment, the pipe member having inside the through-hole 41 square in cross section has been used, but as shown in FIG. 12A, a quadrangular columnar member having a slit 40c formed on the other-side surface 40b side may be used, or as shown in FIG. 12B, a columnar member having an I-shape in cross section may be used.

Furthermore, in the above embodiment, the case has been illustrated where the heat-dissipating member 40 is attached to the outer surface 15b by the adhesive layer 42 formed by curing the caulking material, but the adhesive layer 42 using a tape with thermal conductivity may be formed.

The heat-dissipating member 40 may be attached using both the tape with thermal conductivity and the caulking material with thermal conductivity. In this case, the adhesive layer 42 may be formed of the caulking material only at each end of the heat-dissipating member 40, and the adhesive layer 42 may be formed of the tape in the other portions.

The scope of the present invention is illustrated not by the meaning described above but by the scope of the claims, and is intended to include the meanings equivalent to the scope of the claims and all modifications within the scope.

### REFERENCE SIGNS LIST

1: CONCENTRATOR PHOTOVOLTAIC PANEL
2: PEDESTAL
3: BASE
4: SUPPORT PORTION
5: DRIVE DEVICE
6: SHAFT
7: BEAM
8: ATTACHMENT RAIL
10: CONCENTRATOR PHOTOVOLTAIC MODULE
11: HOUSING
11b: FLANGE PORTION
12: FLEXIBLE PRINTED CIRCUIT
12a, 12a1, 12a2, 12a3, 12a4, 12a5: WIDE PORTION
12b: NARROW PORTION
12c: BOUNDARY PORTION
12c1: HOLE
12f: FLEXIBLE SUBSTRATE
13: CONCENTRATING PORTION
13f: FRESNEL LENS
15: BOTTOM PLATE
15a: INNER SURFACE
15b: OUTER SURFACE
16: FRAME BODY
17: PACKAGE
18: BALL LENS
19: SECONDARY CONCENTRATING PORTION
20: POWER GENERATING ELEMENT
21: SEALING PORTION
25: FRAME MAIN BODY PORTION
25a: BASE PORTION
25a1: BOTTOM SURFACE
25b: SHORT-SIDE WALL PORTION
25c: LONG-SIDE WALL PORTION
26: BOTTOM PLATE HOLDING PORTION
26a: BOTTOM SURFACE
28: PROTECTIVE MEMBER
28a: SHORT-SIDE PROTECTIVE PLATE
28b: LONG-SIDE PROTECTIVE PLATE
29: SHIELDING MEMBER
30: GROOVE PORTION
31: FIRST GROOVE
32: SECOND GROOVE
33: THIRD GROOVE
35: ATTACHMENT PORTION
40: HEAT-DISSIPATING MEMBER
40a: ONE-SIDE SURFACE
40b: OTHER-SIDE SURFACE
40c: SLIT
41: THROUGH-HOLE
42: ADHESIVE LAYER
100: CONCENTRATOR PHOTOVOLTAIC APPARATUS

## Claims

1. A concentrator photovoltaic module comprising:
a concentrating portion configured by arranging a plurality of concentrating lenses that concentrate sunlight;
a plurality of power generating elements arranged at positions corresponding respectively to the plurality of concentrating lenses;
a plurality of secondary concentrating lenses that are provided corresponding respectively to the plurality of power generating elements and guide the sunlight concentrated by the plurality of concentrating lenses to the plurality of power generating elements; and
a housing that contains the plurality of secondary concentrating lenses and the plurality of power generating elements,
wherein
the housing includes
a resin frame body, and
a metal bottom plate that is fixed to the frame body, and on an inner surface of which the plurality of secondary concentrating lenses and the plurality of power generating elements are arranged, and
one or more heat-dissipating members are attached to an outer surface of the bottom plate, the one or more heat-dissipating members having a columnar shape that extends along the outer surface of the bottom plate and dissipating heat of the bottom plate outward.

2. The concentrator photovoltaic module according to claim 1, wherein the one or more heat-dissipating members are prismatic pipe members made of metal.

3. The concentrator photovoltaic module according to claim 1 or 2, wherein
the frame body includes
a frame main body portion that configures an outer frame, and
a bottom plate holding portion that extends along the inner surface of the bottom plate inside the frame main body portion and is integral with the frame main body portion at both ends, and
a longitudinal direction of the one or more heat-dissipating members intersect with a longitudinal direction of the bottom plate holding portion.

4. The concentrator photovoltaic module according to any one of claims 1 to 3, wherein the one or more heat-dissipating members are attached to the outer surface of the bottom plate via an adhesive layer having thermal conductivity.

5. The concentrator photovoltaic module according to claim 4, wherein the adhesive layer is configured using at least one of a caulking material having thermal conductivity and a tape having thermal conductivity.

6. A concentrator photovoltaic panel comprising a plurality of the concentrator photovoltaic modules according to claim 1 that are arranged.

7. A concentrator photovoltaic apparatus comprising:
the concentrator photovoltaic panel according to claim 6; and
a drive device that drives the concentrator photovoltaic panel to face the sun and follow movement of the sun.

8. A method for manufacturing a concentrator photovoltaic module according to claim 1 that is attached to a concentrator photovoltaic apparatus, wherein
after an intermediate assembly, obtained by attaching the concentrating portion to the housing that contains the plurality of power generating elements and the plurality of secondary concentrating lenses, is attached to an attachment rail of the concentrator photovoltaic apparatus, the one or more heat-dissipating members are attached to the outer surface of the bottom plate.
